(19)

Europäisches
Patentamt
European
Patent Office
Office européen
des brevets

(11) **EP 4 395 167 A1**

(12) **EUROPEAN PATENT APPLICATION**
published in accordance with Art. 153(4) EPC

(43) Date of publication:
**03.07.2024 Bulletin 2024/27**

(21) Application number: **21961839.4**

(22) Date of filing: **28.10.2021**

(51) International Patent Classification (IPC):
**H03F 1/30** (2006.01)

(52) Cooperative Patent Classification (CPC):
**H03F 1/30**

(86) International application number:
**PCT/CN2021/127192**

(87) International publication number:
**WO 2023/070474 (04.05.2023 Gazette 2023/18)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
• **SUN, Jie**
**Shenzhen, Guangdong 518129 (CN)**

• **YI, Liang**
**Shenzhen, Guangdong 518129 (CN)**
• **LI, Ke**
**Shenzhen, Guangdong 518129 (CN)**
• **SUN, Yijun**
**Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

(54) **MULTI-BAND POWER AMPLIFICATION CIRCUIT, RADIO FREQUENCY TRANSCEIVER, AND BASE STATION**

(57) This application discloses a multi-band power amplifier circuit, a radio frequency transceiver, and a base station, and relates to the field of communication technologies, to increase an output power of the multi-band power amplifier circuit and improve a broadband feature of the multi-band power amplifier circuit. The multi-band power amplifier circuit includes: a first power transistor, a second power transistor, a first transmission line, and a first capacitor. A power of the second power transistor is greater than a power of the first power transistor. The multi-band power amplifier circuit has an input end and an output end. Both a gate of the first power transistor and a gate of the second power transistor are connected to the input end. The first transmission line and the first capacitor are connected in series between a drain of the first power transistor and the output end. A drain of the second power transistor is connected to the output end. A first direct current voltage is applied to the drain of the first power transistor. A second direct current voltage is applied to the drain of the second power transistor. The first direct current voltage is less than the second direct current voltage. Both a source of the first power transistor and a source of the second power transistor are connected to a grounding end.

FIG. 3

**Description**

**TECHNICAL FIELD**

This application relates to the field of communication technologies, and in particular, to a multi-band power amplifier circuit, a radio frequency transceiver, and a base station.

**BACKGROUND**

A power amplifier circuit working in a plurality of bands is referred to as a multi-band or wide-band power amplifier circuit. For example, the multi-band power amplifier circuit may work in at least one of the following three states: a first state, a second state, and a third state. In the first state, the multi-band power amplifier circuit works at 758 megahertz MHz to 960 megahertz MHz. In the second state, the multi-band power amplifier circuit works at 1.8 gigahertz GHz and 2.1 gigahertz GHz. In the third state, the multi-band power amplifier circuit works at 1.8 gigahertz GHz, 2.1 gigahertz GHz, and 2.6 gigahertz GHz. With the development of communication technologies, a performance requirement for the multi-band power amplifier circuit is increasingly high. For example, during actual application, the multi-band power amplifier circuit is required to have as high an output power as possible and as good a broadband feature as possible.

Although an existing multi-band power amplifier circuit can simultaneously amplify signals in a plurality of bands, the multi-band power amplifier circuit has poorer performance than a single-band power amplifier circuit. For example, the multi-band power amplifier circuit has a lower output power and a poorer broadband feature than the single-band power amplifier circuit. Therefore, it is urgent to design a multi-band power amplifier circuit with high performance to satisfy an actual application requirement.

**SUMMARY**

This application provides a multi-band power amplifier circuit, a radio frequency transceiver, and a base station, to increase an output power of the multi-band power amplifier circuit and improve a broadband feature of the multi-band power amplifier circuit.

To achieve the foregoing objectives, the following technical solutions are used in embodiments of this application.

According to a first aspect, a multi-band power amplifier circuit is provided. The multi-band power amplifier circuit has an input end and an output end. The multi-band power amplifier circuit includes: a first power transistor, a second power transistor, a first transmission line, and a first capacitor. A power of the second power transistor is greater than a power of the first power transistor. Both a gate of the first power transistor and a gate of the second power transistor are connected to the input end. The first transmission line and the first capacitor are connected in series between a drain of the first power transistor and the output end. A drain of the second power transistor is connected to the output end. A first direct current voltage is applied to the drain of the first power transistor. A second direct current voltage is applied to the drain of the second power transistor. The first direct current voltage is less than the second direct current voltage. Both a source of the first power transistor and a source of the second power transistor are connected to a grounding end.

In the foregoing technical solution, the first direct current voltage is less than the second direct current voltage, to be specific, a drain voltage of the second power transistor is greater than a drain voltage of the first power transistor. Compared with a case in which the first direct current voltage is equal to the second direct current voltage, that the first direct current voltage is less than the second direct current voltage is equivalent to increasing a ratio (referred to as a voltage ratio below) of the drain voltage of the second power transistor to the drain voltage of the first power transistor. Because an impedance transformation ratio is inversely proportional to the voltage ratio, when the voltage ratio is increased, the impedance transformation ratio is decreased. A smaller impedance transformation ratio indicates better broadband performance. Therefore, broadband performance of the multi-band power amplifier circuit is improved. In addition, when the drain voltage of the second power transistor is increased, an output power of the second power transistor is increased. When the drain voltage of the first power transistor is decreased, an output power of the first power transistor is decreased. When an increase amplitude of the drain voltage of the second power transistor is greater than a decrease amplitude of the drain voltage of the first power transistor, the output power of the second power transistor is greater than the output power of the first power transistor, and an amount by which the output power of the second power transistor is increased is greater than an amount by which the output power of the first power transistor is decreased. This is equivalent to increasing an output power of the multi-band power amplifier circuit. Therefore, the output power of the multi-band power amplifier circuit is increased.

In a possible implementation of the first aspect, the first power transistor is a mean transistor, and the second power transistor is a peak transistor. In the foregoing possible implementation, an output power of the mean transistor is less than an output power of the peak transistor, to ensure that the multi-band power amplifier circuit works normally.

In a possible implementation of the first aspect, the multi-band power amplifier circuit further includes a matching circuit. The matching circuit includes a second capacitor. The second capacitor is connected between the drain of the first power transistor and the drain of the second power transistor. In the foregoing possible implementation, when the second capacitor is a capacitor whose capacitance level is a nanofarad nF level or a microfarad $\mu$F level, a low-frequency signal may pass through the second capacitor, so that output equivalent inductors of the first power transistor and the second power transistor are connected in parallel. This is equivalent to decreasing an output equivalent inductance of the multi-band power amplifier circuit. Because a value of an equivalent inductance is inversely proportional to a value of a resonance frequency, when the equivalent inductance of the multi-band power amplifier circuit is decreased, a resonance frequency is increased. Because a value of a resonance frequency of a resonance point corresponding to a maximum amplitude value of impedance is a video bandwidth, a video bandwidth of the multi-band power amplifier circuit is increased.

In a possible implementation of the first aspect, a capacitance level of the second capacitor includes one of the following: a nanofarad nF level, a microfarad $\mu$F level, and a picofarad pF level. In the foregoing possible implementation, when the second capacitor is a capacitor whose capacitance level is the nanofarad nF level or the microfarad $\mu$F level, a low-frequency signal may pass through the second capacitor, so that output equivalent inductors of the first power transistor and the second power transistor are connected in parallel. This is equivalent to decreasing an output equivalent inductance of the multi-band power amplifier circuit. Because a value of an equivalent inductance is inversely proportional to a value of a resonance frequency, when the equivalent inductance of the multi-band power amplifier circuit is decreased, a resonance frequency is increased. Because a value of a resonance frequency of a resonance point corresponding to a maximum amplitude value of impedance is a video bandwidth, a video bandwidth of the multi-band power amplifier circuit is increased. In addition, when the second capacitor is a capacitor whose capacitance level is the picofarad pF level, a fundamental wave signal may pass through the second capacitor, to increase a fundamental wave matching bandwidth.

In a possible implementation of the first aspect, the matching circuit further includes a third capacitor. The third capacitor and the second capacitor are connected in parallel. In the foregoing possible implementation, the second capacitor is a capacitor whose capacitance level is the picofarad pF level. A fundamental wave matching bandwidth may be increased by using the pF-level capacitor. The third capacitor is a capacitor whose capacitance level is the nanofarad nF level or the microfarad $\mu$F level. A video bandwidth of the multi-band power amplifier circuit is increased by using the nF-level capacitor or the $\mu$F-level capacitor.

In a possible implementation of the first aspect, when the capacitance level of the second capacitor is the picofarad pF level, a capacitance level of the third capacitor is the nanofarad nF level or the microfarad $\mu$F level. In the foregoing possible implementation, the second capacitor is a capacitor whose capacitance level is the picofarad pF level. A fundamental wave matching bandwidth may be increased by using the pF-level capacitor. The third capacitor is a capacitor whose capacitance level is the nanofarad nF level or the microfarad $\mu$F level. A video bandwidth of the multi-band power amplifier circuit is increased by using the nF-level capacitor or the $\mu$F-level capacitor.

In a possible implementation of the first aspect, the multi-band power amplifier circuit further includes a second transmission line. The second transmission line is connected between the input end and the gate of the second power transistor. In the foregoing possible implementation, a phase of the second power transistor is compensated for by using the second transmission line, to enable a phase of the first power transistor to be equal to the phase of the second power transistor, and enable an output power of the first power transistor and an output power of the second power transistor to be maximum values.

In a possible implementation of the first aspect, the first transmission line is a quarter-wavelength microstrip. In the foregoing possible implementation, a matching degree of the multi-band power amplifier circuit is improved.

In a possible implementation of the first aspect, the second transmission line is a quarter-wavelength microstrip. In the foregoing possible implementation, a matching degree of the multi-band power amplifier circuit is improved.

According to a second aspect, a radio frequency transceiver is provided. The radio frequency transceiver includes: a third transmission line, a load, and the multi-band power amplifier circuit provided in any one of the foregoing first aspect and the possible implementations of the first aspect. The third transmission line and the load are connected in series between an output end and a grounding end.

In a possible implementation of the second aspect, the third transmission line is a quarter-wavelength microstrip.

In a possible implementation of the second aspect, the radio frequency transceiver further includes a baseband circuit. The baseband circuit is configured to output a multi-band radio frequency signal to the multi-band power amplifier circuit. The multi-band power amplifier circuit is configured to amplify the multi-band radio frequency signal.

According to a third aspect, a base station is provided. The base station includes the multi-band power amplifier circuit provided in any one of the foregoing first aspect and the possible implementations of the first aspect, or the radio frequency transceiver provided in any one of the foregoing second aspect and the possible implementations of the second aspect.

According to a fourth aspect, an integrated circuit is provided. The integrated circuit includes a package and the multi-band power amplifier circuit provided in any one of the foregoing first aspect and the possible implementations of the first aspect. The package is used to package a first power transistor, a second power transistor, and a matching circuit.

It may be understood that, all of the radio frequency transceiver, the base station, and the integrated circuit that are provided above include all content of the multi-band power amplifier circuit provided above. Therefore, for beneficial effects that can be achieved by the radio frequency transceiver, the base station, and the integrated circuit, refer to beneficial effects of the multi-band power amplifier circuit provided above. Details are not described herein again.

## BRIEF DESCRIPTION OF DRAWINGS

FIG. 1 is a schematic diagram of a structure of a radio frequency transceiver according to an embodiment of this application;
FIG. 2 is a schematic diagram of a structure of a DHT power amplifier circuit according to an embodiment of this application;
FIG. 3 is a schematic diagram of a structure of a multi-band power amplifier circuit according to an embodiment of this application;
FIG. 4 is a schematic diagram of a structure of another multi-band power amplifier circuit according to an embodiment of this application;
FIG. 5 is a schematic diagram of a structure of another radio frequency transceiver according to an embodiment of this application;
FIG. 6 is a schematic diagram of a partial structure of a multi-band power amplifier circuit according to an embodiment of this application;
FIG. 7 is a schematic diagram of a partial structure of another multi-band power amplifier circuit according to an embodiment of this application;
FIG. 8 is a schematic diagram of a partial structure of still another multi-band power amplifier circuit according to an embodiment of this application;
FIG. 9 is a simulation diagram of a multi-band power amplifier circuit according to an embodiment of this application;
FIG. 10 is a simulation diagram of another multi-band power amplifier circuit according to an embodiment of this application;
FIG. 11 is a simulation diagram of still another multi-band power amplifier circuit according to an embodiment of this application;
FIG. 12(a) is a schematic diagram of a structure of a multi-band power amplifier circuit according to an embodiment of this application;
FIG. 12(b) is a schematic diagram of a structure of another multi-band power amplifier circuit according to an embodiment of this application;
FIG. 13 is a simulation diagram of a multi-band power amplifier circuit according to an embodiment of this application;
FIG. 14 is a schematic diagram of a structure of another multi-band power amplifier circuit according to an embodiment of this application;
FIG. 15(a) is a schematic diagram of a structure of still another multi-band power amplifier circuit according to an embodiment of this application; and
FIG. 15(b) is a schematic diagram of a structure of another multi-band power amplifier circuit according to an embodiment of this application.

## DESCRIPTION OF EMBODIMENTS

In this application, "at least one" means one or more, and "a plurality of" means two or more. "And/or" describes an association relationship of associated objects and represents that three relationships may exist. For example, A and/or B may represent the following cases: Only A exists, both A and B exist, and only B exists, where A and B may be in a singular form or a plural form. The character "/" generally indicates an "or" relationship between the associated objects. "At least one of the following items (pieces)" or a similar expression thereof indicates any combination of these items, including a single item (piece) or any combination of a plurality of items (pieces). For example, at least one of a, b, or c may represent: a, b, c, a and b, a and c, b and c, or a, b, and c, where a, b, and c may be single or may be plural. In addition, in embodiments of this application, terms such as "first" and "second" are used for distinguishing between same objects or similar objects that have basically the same functions or purposes. For example, a first threshold and a second threshold are merely used for distinguishing between different thresholds, and a sequence thereof is not limited.

A person skilled in the art may understand that terms such as "first" and "second" do not limit a quantity and an execution sequence. In embodiments of this application, a connection may include a direct connection and an indirect connection. The direct connection may refer to that two connected components are adjacent on a connection path or there is no other component between the two components. The indirect connection may refer to that two connected components are not adjacent on a connection path or there is another component between the two components, in other words, the two components are connected by using the another component.

It should be noted that, in this application, the terms such as "example" or "for example" are used to represent giving an example, an illustration, or a description. Any embodiment or design scheme described as an "example" or with "for example" in this application should not be explained as being more preferred or having more advantages than another embodiment or design scheme. Exactly, use of the terms such as "example" or "for example" is intended to present a related concept in a specific manner.

Before embodiments of this application are described, a type of a power transistor in embodiments of this application is first described.

The power transistor in embodiments of this application may be a metal oxide semiconductor (metal oxide semiconductor, MOS) transistor. The type of the power transistor may include an N-type metal oxide semiconductor (N-type metal oxide semiconductor, NMOS) transistor and a P-type metal oxide semiconductor (P-type metal oxide semiconductor, PMOS) transistor. The PMOS transistor is used as an example of the power transistor in embodiments of this application for description.

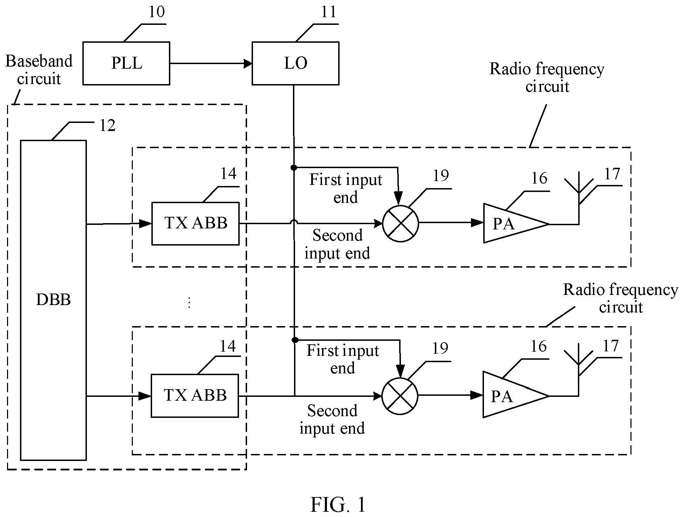

FIG. 1 is a schematic diagram of a possible structure of a radio frequency transceiver according to an embodiment of this application. The radio frequency transceiver may be used in a communication apparatus. As shown in FIG. 1, the radio frequency transceiver includes a phase-locked loop (phase-locked loop, PLL) 10, a local oscillator (local oscillator generator, LO) 11, a digital baseband (digital baseband, DBB) circuit 12, and a plurality of radio frequency circuits. Each radio frequency circuit includes a transmit analog baseband (transmit analog baseband, TX ABB) circuit 14, a power amplifier (power amplifier, PA) 16, an antenna 17, and a frequency mixer 19. The PA 16 may be implemented by a multi-band power amplifier circuit provided in embodiments of this application. In a possible design, the DBB circuit 12 and the TX ABB circuit 14 are collectively referred to as a baseband circuit.

First, connection relationships between the foregoing components are described.

An output end of the PLL 10 is connected to an input end of the LO 11. For each radio frequency circuit, an output end of the LO 11 is connected to a first input end of the frequency mixer 19.

On a transmit link of each radio frequency circuit, the DBB circuit 12 is connected to an input end of the TX ABB circuit 14, an output end of the TX ABB circuit 14 is connected to a second input end of the frequency mixer 19, an output end of the frequency mixer 19 is connected to an input end of the PA 16, and an output end of the PA 16 is connected to the antenna 17.

The following describes functions of the foregoing components.

The PLL 10 is configured to output a first oscillation signal at a fixed clock frequency of each channel to the LO 11.

The LO 11 is configured to: process the first oscillation signal, and output transmit oscillation signals at a plurality of local frequencies to the frequency mixer 19.

The DBB circuit 12 is configured to send a digital signal to the transmit link of the radio frequency circuit.

The TX ABB circuit 14 is configured to perform filtering and amplification processing on the digital signal from the DBB circuit 12.

The frequency mixer 19 is configured to: perform frequency mixing on the transmit oscillation signal and a signal that is output by the TX ABB circuit 14, and output, to the PA 16, a signal obtained by performing the frequency mixing.

The PA 16 is configured to amplify the signal obtained by performing the frequency mixing.

The antenna 17 is configured to transmit a signal amplified by the PA 16.

Before the multi-band power amplifier circuit provided in embodiments of this application is described, a conventional doherty (doherty, DHT) power amplifier circuit is first described. The DHT power amplifier circuit is a multi-band power amplifier circuit.

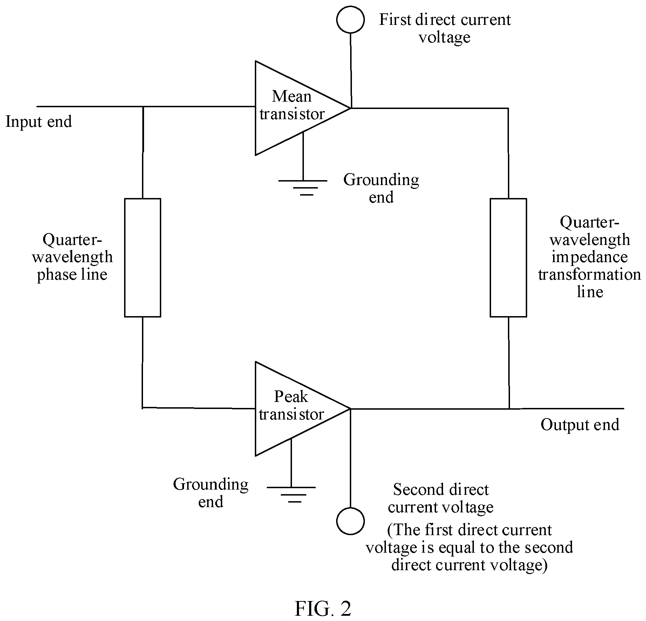

FIG. 2 is a schematic diagram of a structure of a DHT power amplifier circuit. As shown in FIG. 2, the DHT power amplifier circuit includes: a mean transistor, a peak transistor, a quarter-wavelength impedance transformation line, and a quarter-wavelength phase line.

The DHT power amplifier circuit has an input end and an output end. Both a gate of the mean transistor and a first end of the quarter-wavelength phase line are connected to the input end. The quarter-wavelength impedance transformation line is connected between a drain of the mean transistor and the output end. A gate of the peak transistor is connected to a second end of the quarter-wavelength phase line. A drain of the peak transistor is connected to the output end. Both a source of the mean transistor and a source of the peak transistor are connected to a grounding end.

A first direct current voltage is applied to the drain of the mean transistor. A second direct current voltage is applied to the drain of the peak transistor. The first direct current voltage is equal to the second direct current voltage.

For example, both the first direct current voltage and the second direct current voltage may be 50 V

Specifically, functions of the components and/or the circuit shown in FIG. 2 may be as follows.

The mean transistor is configured to amplify an input signal received by the input end of the DHT power amplifier circuit. When the mean transistor reaches a voltage saturation state, the peak transistor is conducted and starts to work. The peak transistor and the mean transistor amplify the input signal together. When the mean transistor does not reach the saturation state, the peak transistor does not work, and only the mean transistor works. An output power of the peak transistor is greater than or equal to an output power of the mean transistor. During actual application, the output power of the peak transistor and the output power of the mean transistor may be set based on an actual requirement. For example, the output power of the peak transistor may be twice the output power of the mean transistor.

When the mean transistor and the peak transistor work simultaneously, the quarter-wavelength impedance transformation line may be configured to decrease an equivalent load of the mean transistor, to increase an output current of the mean transistor. The quarter-wavelength phase line may be configured to compensate for a phase of the peak transistor, to enable the phase of the peak transistor to be equal to a phase of the mean transistor.

Optionally, a working process of the DHT power amplifier circuit shown in FIG. 2 may be divided into the following three phases.

First phase: The input signal received by the input end of the DHT power amplifier circuit is a low-power signal. Only the mean transistor works, and the peak transistor does not work. Specifically, a power of the input signal is amplified after the input signal is transmitted through the mean transistor and the quarter-wavelength impedance transformation line.

Second phase: The power of the input signal received by the input end of the DHT power amplifier circuit is continuously increased. When the mean transistor reaches the voltage saturation state, the peak transistor conducted, and the peak transistor and the mean transistor work together. Specifically, a channel of the input signal is transmitted through the mean transistor and the quarter-wavelength impedance transformation line, and another channel of the input signal is transmitted through the quarter-wavelength phase line and the peak transistor. The power of the input signal is amplified. In this case, an output voltage of the mean transistor in the voltage saturation state is constant. However, because the equivalent load of the mean transistor is continuously decreased, and the output current of the mean transistor is continuously increased, the power of the input signal can be continuously amplified.

Third phase: The power of the input signal received by the input end of the DHT power amplifier circuit is continuously increased. The output voltage of the mean transistor in the voltage saturation state is constant. The output current is continuously increased, until the peak transistor also reaches the voltage saturation state, where both the output current of the mean transistor and an output current of the peak transistor reach maximum values. In this case, an output power of the DHT power amplifier circuit also reaches a maximum value.

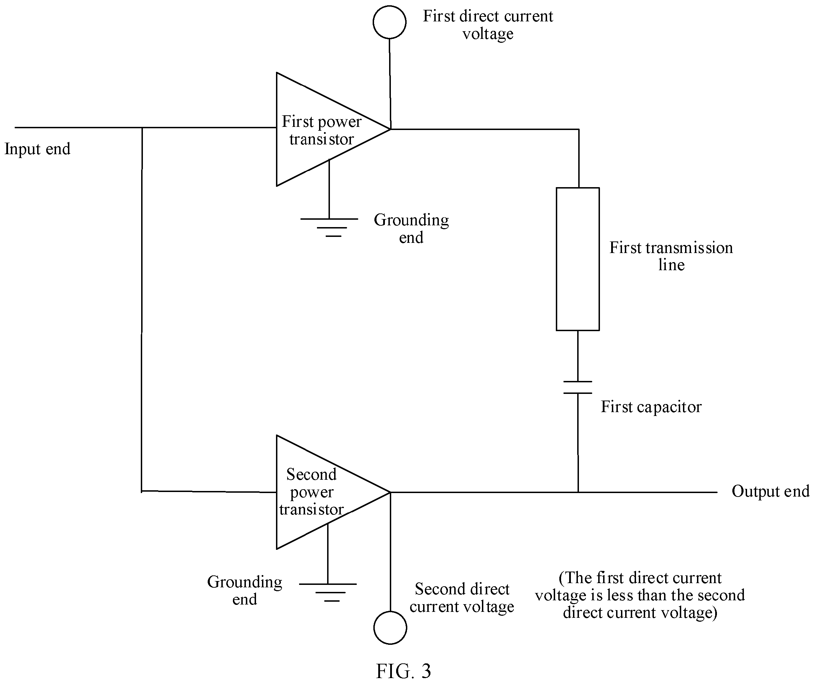

FIG. 2 shows the DHT power amplifier circuit. FIG. 3 is a schematic diagram of a structure of a multi-band power amplifier circuit according to an embodiment of this application. As shown in FIG. 3, the multi-band power amplifier circuit includes: a first power transistor, a second power transistor, a first transmission line, and a first capacitor. A power of the second power transistor is greater than a power of the first power transistor.

The multi-band power amplifier circuit has an input end and an output end. Both a gate of the first power transistor and a gate of the second power transistor are connected to the input end of the multi-band power amplifier circuit. The first transmission line and the first capacitor are connected in series between a drain of the first power transistor and the output end of the multi-band power amplifier circuit. A drain of the second power transistor is connected to the output end of the multi-band power amplifier circuit. A first direct current voltage is applied to the drain of the first power transistor. A second direct current voltage is applied to the drain of the second power transistor. The first direct current voltage is less than the second direct current voltage. Both a source of the first power transistor and a source of the second power transistor are connected to a grounding end.

The first power transistor may be a mean transistor, and the second power transistor may be a peak transistor. In addition, the first direct current voltage is less than the second direct current voltage. For example, during actual application, the first direct current voltage may be 40 V, and the second direct current voltage may be 65 V

In this embodiment of this application, functions of the components of the multi-band power amplifier circuit shown in FIG. 3 may be as follows.

The first power transistor is configured to amplify an input signal of the multi-band power amplifier circuit. When the first power transistor reaches a voltage saturation state, the second power transistor is configured to amplify the input signal of the multi-band power amplifier circuit together with the first power transistor. When the first power transistor does not reach the voltage saturation state, the second power transistor does not work, and only the first power transistor works. An output power of the second power transistor is greater than or equal to an output power of the first power transistor. For example, the output power of the second power transistor may be twice the output power of the first power transistor.

When the first power transistor and the second power transistor work simultaneously, the first transmission line may be configured to decrease an equivalent load of the first power transistor, to increase an output current of the first power transistor. In an implementation, the first transmission line is a quarter-wavelength impedance transformation line. The first capacitor may be configured to separate direct current signals of the first power transistor and the second power transistor, to enable a drain voltage of the first power transistor to be not equal to a drain voltage of the second power transistor.

Optionally, a working process of the multi-band power amplifier circuit shown in FIG. 3 may be divided into the following three phases.

First phase: Specifically, a difference between the first phase shown in FIG. 3 and the first phase shown in FIG. 2 lies in that after the input signal is further transmitted through the first capacitor, a power of the input signal is amplified.

Second phase: Specifically, a difference between the second phase shown in FIG. 3 and the second phase shown in FIG. 2 lies in that after a channel of the input signal of the multi-band power amplifier circuit is transmitted through the first capacitor, and another channel of the input signal is transmitted through the second power transistor, the power of the input signal is amplified.

Third phase: The third phase shown in FIG. 3 is the same as the third phase shown in FIG. 2, and details are not described herein again. For details, refer to related descriptions in FIG. 2.

It should be noted that, in the multi-band power amplifier circuit shown in FIG. 3 in this application, because the first direct current voltage is set to be less than the second direct current voltage, and the setting is different from the setting in FIG. 2, an output power of the entire circuit is different. Therefore, the multi-band power amplifier circuit shown in FIG. 3 has better performance than the DHT power amplifier circuit shown in FIG. 2. This is specifically described in subsequent paragraphs in this application.

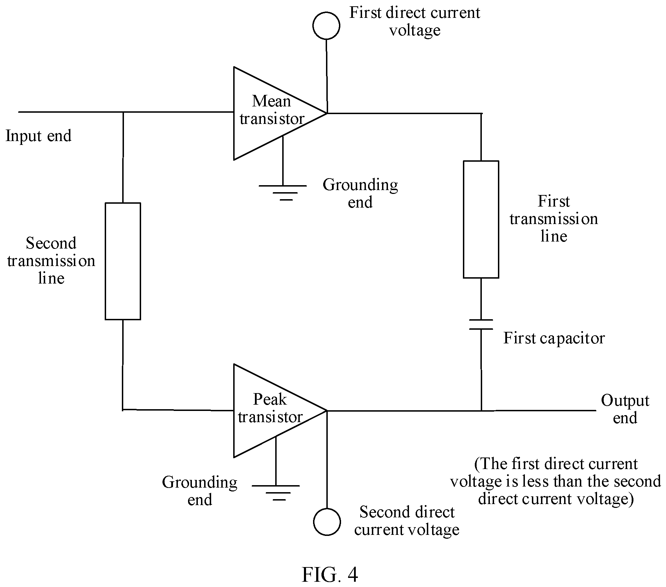

In a possible embodiment, the multi-band power amplifier circuit may further include a second transmission line. The following describes, with reference to FIG. 4, another multi-band power amplifier circuit according to an embodiment of this application.

Optionally, as shown in FIG. 4, the multi-band power amplifier circuit may further include the second transmission line. The second transmission line is connected between the input end of the multi-band power amplifier circuit and the gate of the second power transistor. In this case, the input end of the multi-band power amplifier circuit is connected to the second power transistor through the second transmission line, in other words, a connection between the input end of the multi-band power amplifier circuit and the second power transistor is an indirect connection. The second transmission line may be configured to compensate for a phase of the second power transistor, to enable the phase of the second power transistor to be equal to a phase of the first power transistor, and enable the output power of the second power transistor to reach a maximum value. In an implementation, the second transmission line is a quarter-wavelength phase line.

In a possible embodiment, as shown in FIG. 4, an example in which the first power transistor is the mean transistor and the second power transistor is the peak transistor is used. The first direct current voltage is applied to a drain of the mean transistor, and the second direct current voltage is applied to a drain of the peak transistor, that is, a drain voltage of the mean transistor is less than a drain voltage of the peak transistor. Functions of the circuit and the components that form the multi-band power amplifier circuit shown in FIG. 4 and a working process of the multi-band power amplifier circuit are consistent with those described in FIG. 3, and details are not described herein again.

Optionally, during specific implementation, at least one of the first transmission line and the second transmission line may be a microstrip having specific characteristic impedance and an electrical length of a quarter wavelength. A value of the characteristic impedance is related to parameters such as a width and a length of the microstrip. For example, when characteristic impedance of an input end of the microstrip is equal to characteristic impedance of an output end of the microstrip, the microstrip is a phase line and may be configured to compensate for a phase of the peak transistor, to enable the phase of the peak transistor to be equal to a phase of the mean transistor, and enable an output power of the peak transistor to reach a maximum value. When the characteristic impedance of the input end of the microstrip is not equal to the characteristic impedance of the output end of the microstrip, the microstrip is an impedance transformation line and may be configured to decrease an equivalent load of the mean transistor, to increase an output current of the mean transistor.

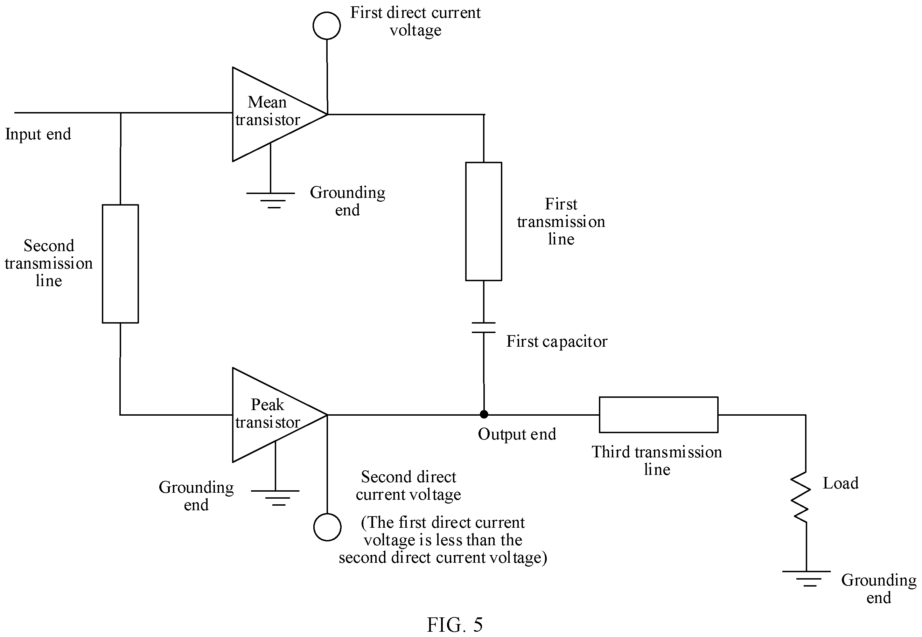

FIG. 5 shows a radio frequency transceiver according to an embodiment of this application. The radio frequency transceiver includes the multi-band power amplifier circuit shown in FIG. 3 or FIG. 4, a third transmission line, and a load. As shown in FIG. 5, the third transmission line and the load are connected in series between an output end and a grounding end of the multi-band power amplifier circuit. The third transmission line may be configured to: combine two channels of signals output by the output end of the multi-band power amplifier circuit into one channel of signal, and transmit the channel of signal to the load. In an implementation, the third transmission line is a quarter-wavelength impedance transformation line.

Optionally, during specific implementation, the third transmission line may be a microstrip having specific characteristic impedance and an electrical length of a quarter wavelength. A value of the characteristic impedance is related to parameters such as a width and a length of the microstrip. For example, when the characteristic impedance is 100 ohm, impedance transformation may be implemented. A specific value of the characteristic impedance may be determined based on an actual requirement and experience of a related person skilled in the art. This is not specifically limited in this embodiment of this application.

Broadband performance is related to an impedance transformation ratio, and a smaller impedance transformation ratio indicates better broadband performance. Therefore, the multi-band power amplifier circuit provided in embodiments of this application has good broadband performance. The following describes in detail an impedance transformation ratio of the multi-band power amplifier circuit.

Compared with the DHT power amplifier circuit shown in FIG. 2, in the multi-band power amplifier circuit provided in embodiments of this application, the first direct current voltage is less than the second direct current voltage, and this is equivalent to increasing the drain voltage of the second power transistor and decreasing the drain voltage of the first power transistor, in other words, increasing a ratio of the drain voltage of the second power transistor to the drain voltage of the first power transistor. Because an impedance transformation ratio r satisfies Formula (1):

$$r = \frac{(1+k)^2}{x^2} \quad (1)$$

k is a back-off parameter. When a back-off value of the multi-band power amplifier circuit is fixed, k is a fixed value. x is a voltage ratio (to be specific, the ratio of the drain voltage of the second power transistor to the drain voltage of the first power transistor). It can be learned from Formula (1) that, when the back-off value of the multi-band power amplifier circuit is fixed, the impedance transformation ratio r is inversely proportional to the voltage ratio x. When the voltage ratio x is increased, the impedance transformation ratio r is decreased.

In the multi-band power amplifier circuit provided in embodiments of this application, the voltage ratio x is increased. Therefore, the impedance transformation ratio r is decreased. Because a smaller impedance transformation ratio r indicates better broadband performance, the multi-band power amplifier circuit has good broadband performance.

In addition, compared with the DHT power amplifier circuit shown in FIG. 2, in the multi-band power amplifier circuit provided in embodiments of this application, the first direct current voltage is less than the second direct current voltage, and this is equivalent to increasing the drain voltage of the second power transistor and decreasing the drain voltage of the first power transistor. In addition, during actual application, generally, an increase amplitude of the drain voltage of the second power transistor is set to be greater than a decrease amplitude of the drain voltage of the first power transistor by adjusting specific values of the first direct current voltage and the second direct current voltage. When the drain voltage of the second power transistor is increased, the output power of the second power transistor is increased. When the drain voltage of the first power transistor is decreased, the output power of the first power transistor is decreased. It is assumed that the output power of the second power transistor is greater than the output power of the first power transistor. For example, the first power transistor is disposed as the mean transistor and the second power transistor is disposed as the peak transistor. In this case, an amount by which the output power of the second power transistor is increased is greater than an amount by which the output power of the first power transistor is decreased. Because the output power of the multi-band power amplifier circuit is equal to a sum of the output power of the first power transistor and the output power of the second power transistor, and the amount by which the output power of the second power transistor is increased is greater than the amount by which the output power of the first power transistor is decreased, the output power of the multi-band power amplifier circuit is increased.

In conclusion, compared with the DHT power amplifier circuit, for the multi-band power amplifier circuit provided in embodiments of this application, broadband performance of the multi-band power amplifier circuit can be improved when increasing the output power of the multi-band power amplifier circuit. In other words, the multi-band power amplifier circuit has a high output power and good broadband performance.

Further, the multi-band power amplifier circuit causes linear deterioration and an efficiency reduction in a multi-band work mode. To reduce linear deterioration and the efficiency reduction of the multi-band power amplifier circuit in the multi-band work mode, a video bandwidth (video bandwidth, VBW) of the multi-band power amplifier circuit needs to be increased. The VBW is a resonance frequency corresponding to a maximum amplitude value of impedance of the multi-band power amplifier circuit.

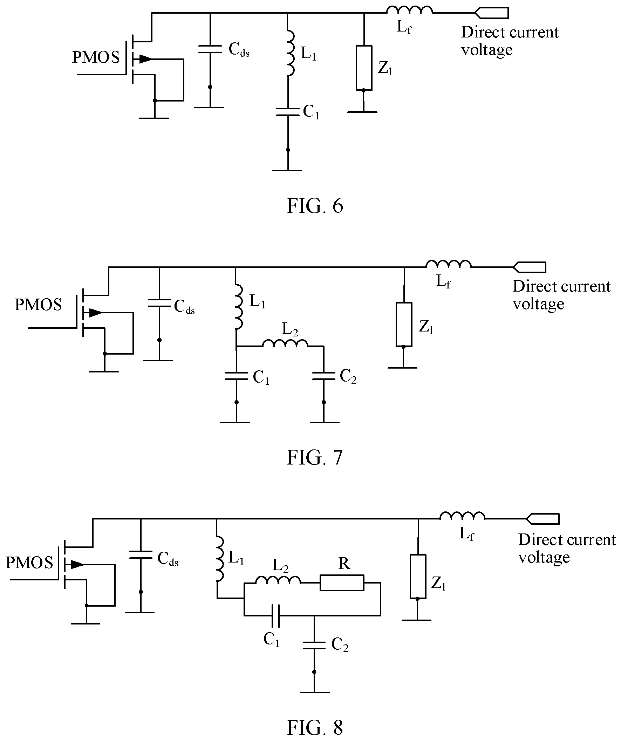

In some solutions, the VBW may be increased by adding a one-order or multi-order low-pass network to a drain of a power transistor. In a solution, as shown in FIG. 6, a one-order low-pass network including a capacitor $C_1$ and an inductor $L_1$ is added to a drain of a PMOS transistor. After the one-order low-pass network is added, an increase of the VBW of the multi-band power amplifier circuit is not significant. Alternatively, in another solution, as shown in FIG. 7, a two-order low-pass network including a capacitor $C_1$, an inductor $L_1$, a capacitor $C_2$, and an inductor $L_2$ is added to a drain of a PMOS transistor. Alternatively, in still another solution, as shown in FIG. 8, a two-order low-pass network including a capacitor $C_1$, an inductor $L_1$, a capacitor $C_2$, an inductor $L_2$, and a resistor R is added to a drain of a PMOS transistor. After the two-order low-pass network is added, the VBW of the multi-band power amplifier circuit is significantly increased, but an additional resonance point is introduced around dozens of MHz. In FIG. 6, FIG. 7, and FIG. 8, $C_{ds}$ is a parasitic capacitor of the PMOS transistor. The capacitor $C_{ds}$ is configured to form a resonant circuit with an inductor Lf. A direct current voltage may be used to supply power to the drain of the PMOS transistor. $L_f$ is a choke inductor, and may be configured to: block an alternating current and allowing a direct current. $Z_l$ is a load. FIG. 6, FIG. 7, and FIG. 8 show only partial structures of the power amplifier circuit.

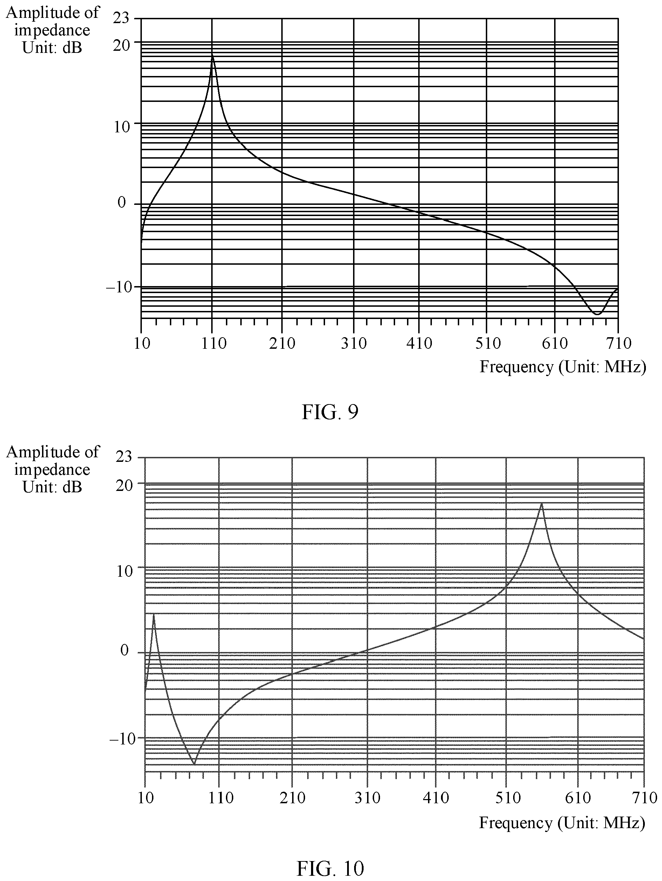

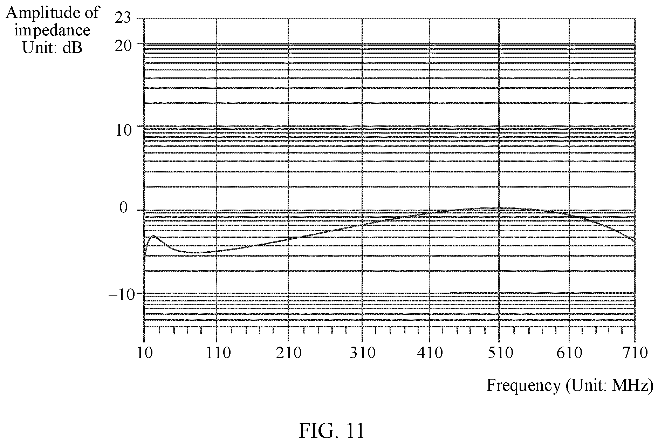

Simulation diagrams of the multi-band power amplifier circuit shown in FIG. 6, FIG. 7, and FIG. 8 are respectively shown in FIG. 9, FIG. 10, and FIG. 11, where a horizontal coordinate represents a frequency, a vertical coordinate represents an amplitude of impedance, and a local maximum value point represents a resonance point. A value of a horizontal coordinate corresponding to a maximum amplitude value of the impedance is the VBW. It can be learned that, when a specific value of each component in the multi-band power amplifier circuit shown in FIG. 6 is set, the VBW is about 110 MHz. An increase effect of the VBW is not significant. When a specific value of each component in the multi-band power amplifier circuit shown in FIG. 7 and a specific value of each component in the multi-band power amplifier circuit shown in FIG. 8 are set, the VBWs are about 550 MHz and 510 MHz respectively. Although the VBWs can be increased, additional resonance points are introduced around 20 MHz. It can be learned from FIG. 10 and FIG. 11 that, an additional resonance point is introduced at a position of 20 MHz, affecting linear correction. In addition, the multi-band power amplifier circuit shown in FIG. 8 uses the resistor R to reduce a figure of merit of the resonance point, but an additional loss is introduced.

However, in embodiments of this application, a matching circuit is added to increase the VBW of the multi-band power amplifier circuit. The following describes the matching circuit in detail.

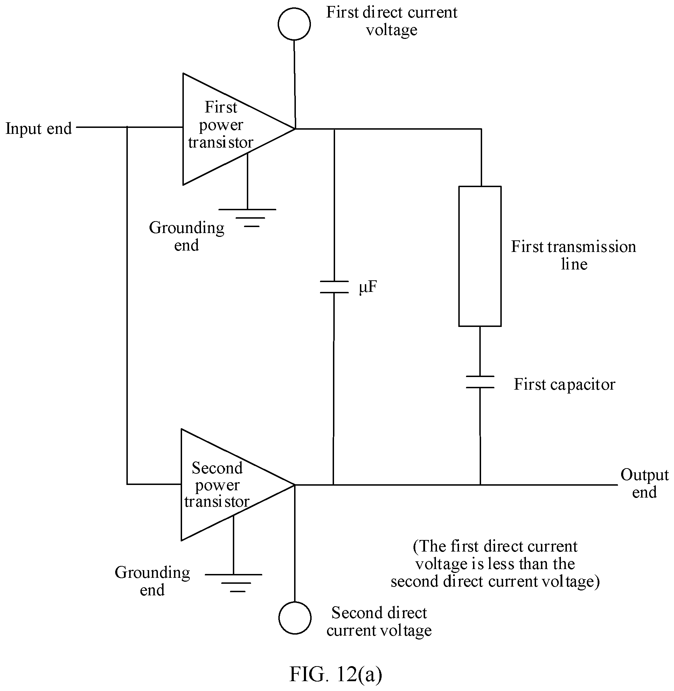

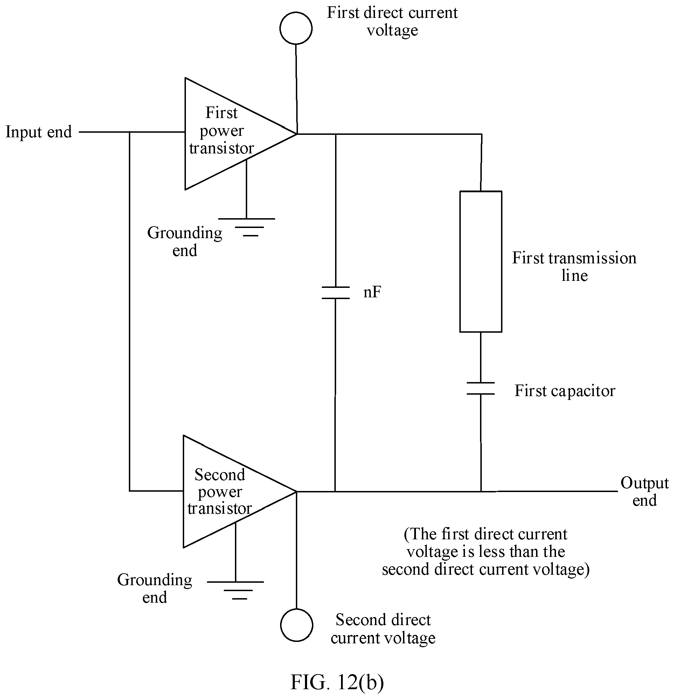

In a possible embodiment, the multi-band power amplifier circuit further includes the matching circuit. The matching circuit may include a second capacitor. The second capacitor is connected between the drain of the first power transistor and the drain of the second power transistor. FIG. 12(a) and FIG. 12(b) show structures of the multi-band power amplifier circuit whose matching circuit includes the second capacitor.

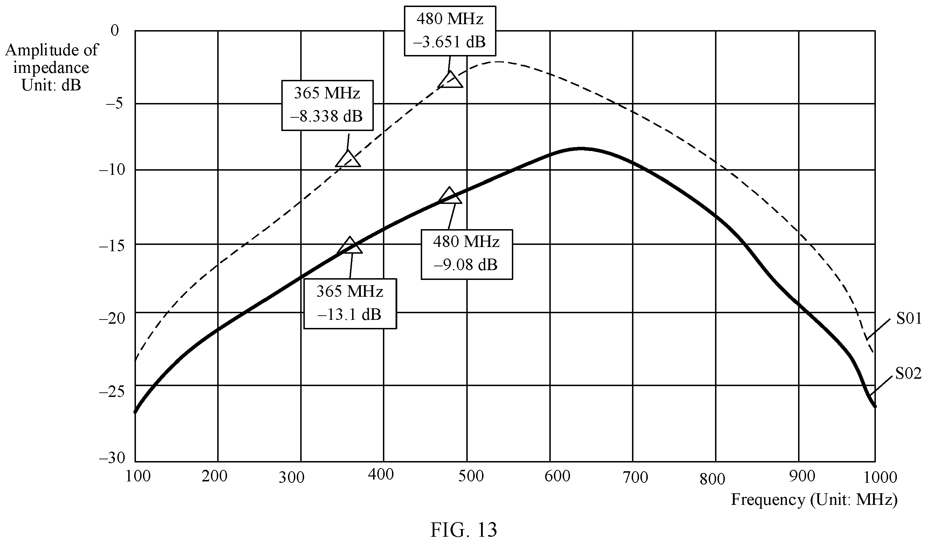

A capacitance level of the second capacitor may be a nanofarad (nF) level or a microfarad (μF) level. FIG. 12(a) and FIG. 12(b) respectively show the structures of the multi-band power amplifier circuit when the capacitance level of the second capacitor is the microfarad (μF) level and when the capacitance level of the second capacitor is the nanofarad (nF) level. When the capacitance level of the second capacitor is the microfarad (μF) level or the nanofarad (nF) level, the VBW of the multi-band power amplifier circuit is increased. With reference to FIG. 13, the following describes a principle of increasing the VBWs of the multi-band power amplifier circuit in FIG. 12(a) and FIG. 12(b).

For example, in a simulation diagram shown in FIG. 13, it can be learned that, a specific value may be set for each component in the multi-band power amplifier circuit provided in FIG. 12(a) or FIG. 12(b), to enable the VBW of the multi-band power amplifier circuit to be 640 MHz. However, when the same value of each component corresponding to FIG. 12(a) or FIG. 12(b) is set for the DHT power amplifier circuit shown in FIG. 2, a VBW of the DHT power amplifier circuit is 520 MHz. Therefore, the VBW of the multi-band power amplifier circuit provided in embodiments of this application is greater than the VBW of the circuit shown in FIG. 2. For example, in the simulation diagram shown in FIG. 13, a horizontal coordinate is a resonance frequency, and a vertical coordinate is an amplitude of impedance. A curve S01 is a simulation curve of a relationship between an amplitude of impedance and a frequency of the DHT power amplifier circuit shown in FIG. 2. A curve S02 is a simulation curve of a relationship between an amplitude of the impedance and a frequency of the multi-band power amplifier circuit. As shown in FIG. 13, in the curve S02, no additional resonance point except a resonance point corresponding to the VBW is introduced by the multi-band power amplifier circuit provided in embodiments of this application. In this way, linear correction of the multi-band power amplifier circuit can be ensured. In addition, an overall amplitude of the impedance corresponding to the curve S02 is less than the amplitude of the impedance corresponding to the curve S01. A lower amplitude of impedance indicates better broadband performance. Therefore, the multi-band power amplifier circuit provided in embodiments of this application has good broadband performance.

In an aspect, because the second capacitor does not involve an LC resonant circuit, introduction of an additional resonance point that is caused by the LC resonant circuit can be avoided. In addition, because the second capacitor does not involve a resistor, an additional loss caused by introducing the resistor is avoided.

In another aspect, in an actual circuit, equivalent inductors connected in parallel exist at an output end of the first power transistor and an output end of the second power transistor. When the capacitance level of the second capacitor is the μF level or the nF level, a low-frequency signal may be transmitted through the second capacitor, so that the output equivalent inductors of the first power transistor and the second power transistor are connected in parallel, to decrease an output equivalent inductance of the multi-band power amplifier circuit. A resonance frequency f satisfies Formula (2):

$$f = \frac{1}{2\pi\sqrt{LC}} \quad (2)$$

L is an equivalent inductance, and C is an equivalent capacitance. It can be learned from the formula that a value of the equivalent inductance L or the equivalent capacitance C is inversely proportional to a value of the resonance frequency f. Therefore, when the second capacitor is connected in parallel to the first transmission line and the first capacitor, the equivalent inductance of the multi-band power amplifier circuit is decreased, and the resonance frequency is increased. Further, because a value of the resonance frequency of the resonance point corresponding to the maximum amplitude value of the impedance is the VBW, when the resonance frequency of the multi-band power amplifier circuit is increased, the VBW of the multi-band power amplifier circuit is increased.

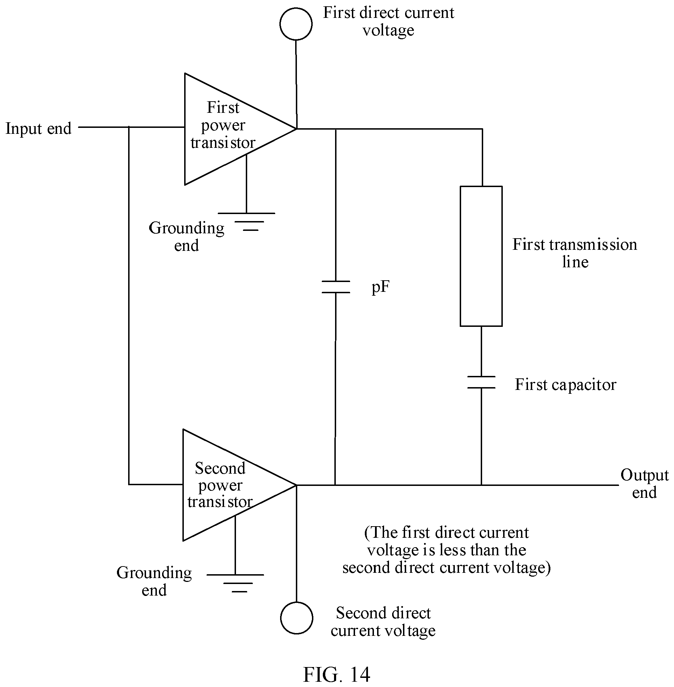

Further, the capacitance level of the second capacitor may be a picofarad (pF) level. FIG. 14 shows a structure of the multi-band power amplifier circuit when the capacitance level of the second capacitor is the picofarad (pF) level. When the capacitance level of the second capacitor is the picofarad (pF) level, a fundamental wave matching bandwidth may be increased. Optionally, the fundamental wave matching bandwidth may be measured by using an impedance error. The impedance error indicates an error between actual fundamental wave impedance and target fundamental wave impedance. An impedance error $\varepsilon$ satisfies the following Formula (3):

$$\varepsilon = 20 \cdot \lg \left| \frac{Z_m - Z_t}{Z_m - Z_t^*} \right| \quad \text{Formula (3)}$$

$Z_m$ represents actual fundamental wave impedance, $Z_t$ represents target fundamental wave impedance, and $Z_t^*$ represents conjugate of $Z_t$. A smaller value of the impedance error indicates a wider fundamental wave matching bandwidth and a better fundamental wave matching degree, and further indicates a smaller performance difference between the multi-band power amplifier circuit and a single-band power amplifier circuit in terms of linearity, efficiency, or the like in a specific band. For example, when fundamental wave frequencies are 1840 MHz and 2140 MHz, calculation results of impedance errors of the DHT power amplifier circuit shown in FIG. 2 and the multi-band power amplifier circuit provided in embodiments of this application are shown in the following Table 1. It can be learned that, at two different fundamental wave frequencies, all of impedance errors of the multi-band power amplifier circuit provided in FIG. 14 are less than the impedance errors of the DHT power amplifier circuit shown in FIG. 2. Therefore, for the multi-band power amplifier circuit provided in FIG. 14, the fundamental wave matching bandwidth may be increased.

**Table 1**

| Calculation result of the impedance error | | |
|---|---|---|
| Fundamental wave frequency | 1840 MHz | 2140 MHz |
| Impedance error of the DHT power amplifier circuit shown in FIG. 2 | -15 dB | -18 dB |
| Impedance error of the multi-band power amplifier circuit provided in FIG. 14 | -25 dB | -26 dB |

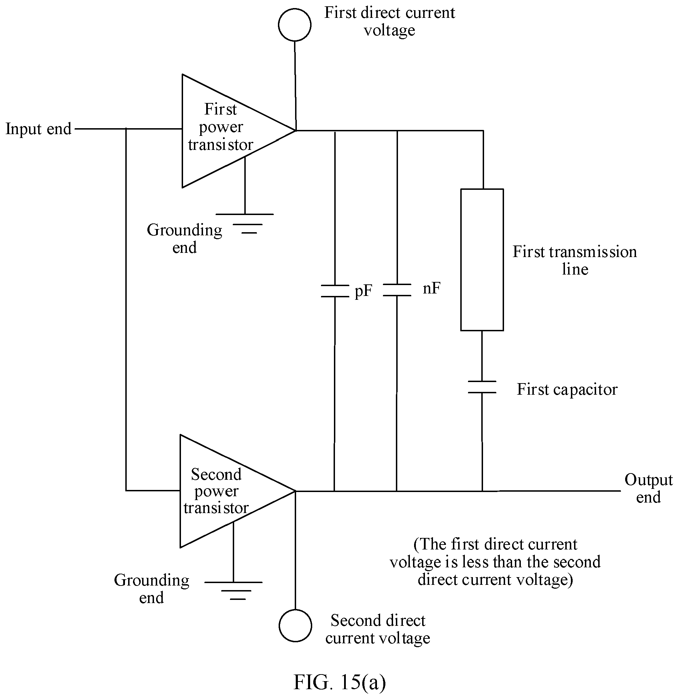

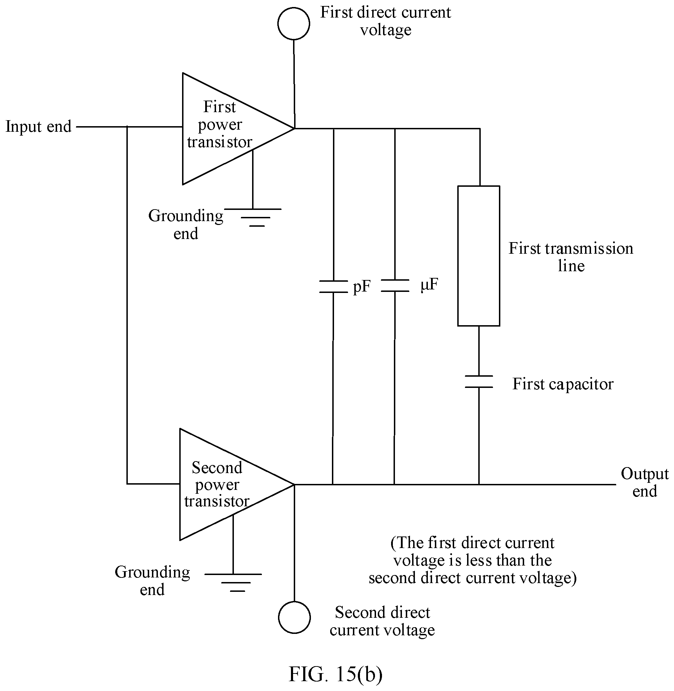

In a possible embodiment, the matching circuit further includes a third capacitor. The third capacitor and the second capacitor are connected in parallel. FIG. 15(a) and FIG. 15(b) show two possible structures of the multi-band power amplifier circuit whose matching circuit includes the third capacitor.

Optionally, when the capacitance level of the second capacitor is the pF level, a capacitance level of the third capacitor may be the nF level or the μF level. FIG. 15(a) shows the structure of the multi-band power amplifier circuit when the capacitance level of the third capacitor is the nF level. FIG. 15(b) shows the structure of the multi-band power amplifier circuit when the capacitance level of the third capacitor is the μF level. In this case, for the multi-band power amplifier circuit, the fundamental wave matching bandwidth may be further increased when increasing the VBW bandwidth, to implement good fundamental wave matching. Therefore, in a specific band, a performance difference between the multi-band power amplifier circuit and the single-band power amplifier circuit in terms of linearity, efficiency, or the like is reduced.

Based on this, an embodiment of this application further provides an integrated circuit. The integrated circuit includes: a package and the multi-band power amplifier circuit provided in FIG. 3, FIG. 4, FIG. 12(a), FIG. 12(b), FIG. 14, FIG. 15(a), or FIG. 15(b). The package is used to package a first power transistor, a second power transistor, and a matching circuit. In other words, the matching circuit may be located inside the package. For example, the matching circuit may be located at an output pad of a first power transistor die or a second power transistor die. This is implemented by using an integrated capacitor element. In this case, areas of the integrated circuit and the multi-band power amplifier circuit may be reduced. Further, when the multi-band power amplifier circuit or the integrated circuit is used in a radio frequency transceiver, an area of the radio frequency transceiver may be reduced, thereby optimizing a layout.

Optionally, the matching circuit may alternatively be located outside the package. For example, the matching circuit may alternatively be located at a root position of an output pin of the first power transistor or the second power transistor. This is implemented by using a surface mount capacitor. Costs are low and circuit debugging is facilitated. This is not specifically limited in this embodiment of this application.

According to an aspect of this application, an embodiment of this application further provides a communication device. The communication device may be a base station or a terminal. The communication device includes a multi-band power amplifier circuit. The multi-band power amplifier circuit may be the multi-band power amplifier circuit described in any one of embodiments in FIG. 3, FIG. 4, FIG. 12(a), FIG. 12(b), FIG. 14, FIG. 15(a), or FIG. 15(b). For specific descriptions of the multi-band power amplifier circuit, refer to the foregoing descriptions. Details are not described herein again in this embodiment of this application.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that this implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A multi-band power amplifier circuit, wherein the multi-band power amplifier circuit has an input end and an output end, and comprises: a first power transistor, a second power transistor, a first transmission line, and a first capacitor, wherein a power of the second power transistor is greater than a power of the first power transistor;
   both a gate of the first power transistor and a gate of the second power transistor are connected to the input end; the first transmission line and the first capacitor are connected in series between a drain of the first power transistor and the output end; a drain of the second power transistor is connected to the output end; a first direct current voltage is applied to the drain of the first power transistor; a second direct current voltage is applied to the drain of the second power transistor; the first direct current voltage is less than the second direct current voltage; and both a source of the first power transistor and a source of the second power transistor are connected to a grounding end.

2. The multi-band power amplifier circuit according to claim 1, wherein the first power transistor is a mean transistor, and the second power transistor is a peak transistor.

3. The multi-band power amplifier circuit according to claim 1 or 2, wherein the multi-band power amplifier circuit further comprises a matching circuit, and the matching circuit comprises a second capacitor; and
   the second capacitor is connected between the drain of the first power transistor and the drain of the second power transistor.

4. The multi-band power amplifier circuit according to claim 3, wherein a capacitance level of the second capacitor comprises one of the following: a nanofarad nF level, a microfarad $\mu$F level, and a picofarad pF level.

5. The multi-band power amplifier circuit according to claim 3 or 4, wherein the matching circuit further comprises a third capacitor, and the third capacitor and the second capacitor are connected in parallel.

6. The multi-band power amplifier circuit according to claim 5, wherein when the capacitance level of the second capacitor is the pF level, a capacitance level of the third capacitor is the nF level or the μF level.

7.  The multi-band power amplifier circuit according to any one of claims 1 to 6, wherein the multi-band power amplifier circuit further comprises a second transmission line, and the second transmission line is connected between the input end and the gate of the second power transistor.

8.  The multi-band power amplifier circuit according to claim 7, wherein the second transmission line is a quarter-wavelength microstrip.

9.  The multi-band power amplifier circuit according to any one of claims 1 to 8, wherein the first transmission line is a quarter-wavelength microstrip.

10. A radio frequency transceiver, wherein the radio frequency transceiver comprises: a third transmission line, a load, and the multi-band power amplifier circuit according to any one of claims 1 to 9; and
    the third transmission line and the load are connected in series between an output end and a grounding end.

11. The radio frequency transceiver according to claim 10, wherein the third transmission line is a quarter-wavelength microstrip.

12. The radio frequency transceiver according to claim 10 or 11, wherein the radio frequency transceiver further comprises a baseband circuit;

    the baseband circuit is configured to output a multi-band radio frequency signal to the multi-band power amplifier circuit; and
    the multi-band power amplifier circuit is configured to amplify the multi-band radio frequency signal.

13. A base station, comprising the multi-band power amplifier circuit according to any one of claims 1 to 9, or comprising the radio frequency transceiver according to any one of claims 10 to 12.

14. An integrated circuit, wherein the integrated circuit comprises: a package and the multi-band power amplifier circuit according to any one of claims 3 to 6, and the package is used to package a first power transistor, a second power transistor, and a matching circuit.

FIG. 1

First direct current voltage

Mean transistor

Grounding end

Input end

Quarter-wavelength phase line

Quarter-wavelength impedance transformation line

Peak transistor

Grounding end

Output end

Second direct current voltage

(The first direct current voltage is equal to the second direct current voltage)

FIG. 2

FIG. 3

First direct current voltage

First transmission line

First capacitor

Output end

Grounding end

First power transistor

Input end

Second power transistor

Grounding end

Second direct current voltage

(The first direct current voltage is less than the second direct current voltage)

First direct current
voltage

Mean
transistor

Input end

Grounding
end

First
transmission
line

Second
transmission
line

First capacitor

Peak
transistor

Output
end

Grounding
end

(The first direct current
voltage is less than the second
direct current voltage)

Second direct
current voltage

FIG. 4

Grounding end

Load

Third transmission line

First transmission line

First capacitor

Output end

First direct current voltage

Grounding end

Second direct current voltage

(The first direct current voltage is less than the second direct current voltage)

Mean transistor

Grounding end

Peak transistor

Grounding end

Input end

Second transmission line

FIG. 5

FIG. 6

FIG. 7

FIG. 8

FIG. 9

FIG. 10

FIG. 11

FIG. 12(a)

First direct current
voltage

First
power
transistor

Input end

Grounding
end

nF

First transmission
line

First capacitor

Second
power
transistor

Output
end

(The first direct current
voltage is less than the
second direct current voltage)

Grounding
end

Second direct
current voltage

FIG. 12(b)

FIG. 13

Amplitude of impedance
Unit: dB

Frequency (Unit: MHz)

S01
S02

480 MHz
−3.651 dB

365 MHz
−8.338 dB

480 MHz
−9.08 dB

365 MHz
−13.1 dB

FIG. 14

First direct current
voltage

First
power
transistor

Grounding
end

pF   nF

First transmission
line

First capacitor

Input end

Second
power
transistor

Grounding
end

Output
end

(The first direct current
voltage is less than the second
direct current voltage)

Second direct
current voltage

FIG. 15(a)

First direct current
voltage

First
power
transistor

Input end

Grounding
end

First transmission
line

pF    µF

First capacitor

Second
power
transistor

Output
end

Grounding
end

(The first direct current
voltage is less than the
second direct current voltage)

Second direct
current voltage

FIG. 15(b)

## INTERNATIONAL SEARCH REPORT

| International application No. |
|---|
| **PCT/CN2021/127192** |

**A. CLASSIFICATION OF SUBJECT MATTER**

H03F 1/30(2006.01)i

According to International Patent Classification (IPC) or to both national classification and IPC

**B. FIELDS SEARCHED**

Minimum documentation searched (classification system followed by classification symbols)

H03F

Documentation searched other than minimum documentation to the extent that such documents are included in the fields searched

Electronic data base consulted during the international search (name of data base and, where practicable, search terms used)

CNPAT, CNKI, WPI, EPODOC: 多频段, 多波段, 功率放大电路, 功率管, 第二, 直流电压, 电流, 高, 低, 增大, 传输线, 输出功率, 栅极, 漏极, 宽带, 基站, multi-band, power amplification circuit, power pipe, second, direct voltage, current, high, low, increase, transmission line, output power, gate, drain, wideband, base station, BS

**C. DOCUMENTS CONSIDERED TO BE RELEVANT**

| Category* | Citation of document, with indication, where appropriate, of the relevant passages | Relevant to claim No. |
|---|---|---|
| A | CN 103986425 A (CHINA UNICHIP TECHNOLOGIES INC.) 13 August 2014 (2014-08-13) claims 1-8 | 1-14 |
| A | CN 101867347 A (INSTITUTE OF ELECTRONICS, CHINESE ACADEMY OF SCIENCES) 20 October 2010 (2010-10-20) entire document | 1-14 |
| A | CN 106849981 A (AUCTUS TECHNOLOGIES CO., LTD.) 13 June 2017 (2017-06-13) entire document | 1-14 |
| A | CN 107547050 A (TIANJIN UNIVERSITY) 05 January 2018 (2018-01-05) entire document | 1-14 |
| A | CN 207490871 U (CHENGDU TEPRO TECHNOLOGY CO., LTD.) 12 June 2018 (2018-06-12) entire document | 1-14 |
| A | EP 2293435 A1 (ALCATEL LUCENT) 09 March 2011 (2011-03-09) entire document | 1-14 |
| A | EP 2819304 A1 (NXP B. V.) 31 December 2014 (2014-12-31) entire document | 1-14 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 May 2022** | **26 May 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT
### Information on patent family members

International application No.

**PCT/CN2021/127192**

| Patent document cited in search report | | | Publication date (day/month/year) | Patent family member(s) | | | Publication date (day/month/year) |
|---|---|---|---|---|---|---|---|
| CN | 103986425 | A | 13 August 2014 | None | | | |
| CN | 101867347 | A | 20 October 2010 | None | | | |
| CN | 106849981 | A | 13 June 2017 | None | | | |
| CN | 107547050 | A | 05 January 2018 | None | | | |
| CN | 207490871 | U | 12 June 2018 | None | | | |
| EP | 2293435 | A1 | 09 March 2011 | None | | | |
| EP | 2819304 | A1 | 31 December 2014 | US | 2015002230 | A1 | 01 January 2015 |

Form PCT/ISA/210 (patent family annex) (January 2015)